# EUROPEAN PATENT APPLICATION

(11) **EP 1 100 069 A1**
(43) Date of publication of application: **16.05.2001**
(21) Application number: 00124425.0
(22) Date of filing: 08.11.2000
(51) Int. Cl.: G10H 1/34, H03M 11/22

(54) **Keyboard having multi-bit key switches**

(30) Priority: 10.11.1999 JP 31919499
(71) Applicant: NEC CORPORATION, Tokyo (JP)
(72) Inventor: Urayama, Yasuhiko, c/o NEC Yamagata, Ltd., Yamagata-shi, Yamagata (JP)
(74) Representative: Baronetzky, Klaus, Dipl.-Ing.

(57) **Abstract**

A keyboard includes a plurality of key switches (11) each including a specified number of key contacts (12) selected from a fixed number (four) of key contacts, and scan lines (13) in number corresponding to the fixed number. Upon depression of one of the key switches (11), the scan lines (13) deliver a specified coded signal depending on the key switch (11) depressed at that time. The coded signal is detected by scan circuits (15) disposed outside the keyboard (10). A large number of coded signals can be delivered from the keyboard (10) with a less number of output terminals (16).

## Description

### BACKGROUND OF THE INVENTION

### (a) Field of the Invention

The present invention relates to a keyboard having multi-bit key switches and, more particularly, to a new keyboard having a plurality of multi-bit key switches and capable of outputting multi-bit signals with a reduced number of output terminals.

### (b) Description of the Related Art

There has been a constant tendency of demand that the configuration of electronic device be simplified to obtain higher-efficient and low-cost electronic appliances. For example, an electronic appliance controlled by a remote control switch should be simplified by reducing the number of output terminals of the remote control switch. If a keyboard used as the remote control switch can output a large number of different coded signals with a less number of output terminals, the costs for the associated electronic appliance can be reduced significantly.

### SUMMARY OF THE INVENTION

In view of the above, it is an object of the present invention to provide a keyboard capable of outputting a large number of different coded signals with a less number of output terminals provided therein.

The present invention provides, in a first aspect thereof, a keyboard including a plurality of key switches each including a fixed number of key contacts and a common key button for making the key contacts closed at a time, and scan lines in number corresponding to the fixed number and each selectively connected to a corresponding one of the key contacts of each of the key switches, whereby each of the key switches outputs a specified signal through the scan lines upon depression of common the key button.

The present invention also provides, in a second aspect thereof, a keyboard including a plurality of key switches each including a specified number of key contacts selected from a fixed number of key contacts and a common key button for making the key contacts closed at a time, and scan lines in number corresponding to the fixed number and each connected to a corresponding one of the key contacts of each of the key switches, whereby each of the key switches outputs a specified signal through the scan lines upon depression of common the key button.

In accordance with the keyboards of the first and second aspects of the present invention, 2ⁿ-1 key switches of the keyboard each having the fixed number of (n) key contacts or a specified number of key contacts selected from the "n" key contacts can output 2ⁿ coded signals through "n" scan lines and through "n" output terminals of the keyboard. That is, a large number (2ⁿ) of coded signals can be output with a less number (n) of output terminals.

The above and other objects, features and advantages of the present invention will be more apparent from the following description, referring to the accompanying drawings.

### BRIEF DESCRIPTION OF THE DRAWINGS

Fig. 1 is a partial circuit diagram of a keyboard according to an embodiment of the present invention, illustrating a specific one of the key switches.

Figs. 2A and 2B are schematic sectional views of the key switch shown in Fig. 1, illustrating an open state and a closed state, respectively, of the key contacts.

Fig. 3 is a schematic diagram illustrating the overall configuration of the keyboard of the embodiment.

Fig. 4 is a table showing coded signals output from the keyboard of Fig. 3.

### PREFERRED EMBODIMENT OF THE INVENTION.

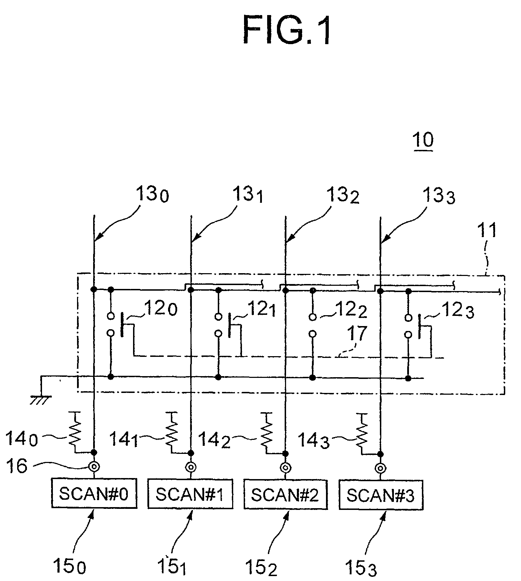

Referring to Fig. 1, a keyboard, generally designated by numeral 10, according to an embodiment of the present invention includes a plurality (2⁴-1=15 in this example) of key switches 11 arranged in a matrix and each including a specified number of key contacts 12 selected from a fixed number of (four) key contacts, scan lines 13 in number corresponding to the fixed number (four) and each extending in a column direction for a corresponding one of the fixed number of key contacts 12, pull-up transistors 14 in number corresponding to the fixed number (four) and each connected between a source line VDD and a corresponding one of the scan lines, and output terminals 16 in number corresponding to the fixed number and connected to the respective scan lines 13. Outside the keyboard 10, scan circuits 15 are disposed for respective scan lines 13 for detecting the coded signals supplied through the output terminals 16.

It is to be noted that all the key switches 11 in the keyboards 10 is associated with four scan lines 13 as well as the four output terminals 16, and each of the four scan lines 13 in a column is connected to a corresponding one of the four scan lines 13 disposed for another column of the key switches 11. In the accompanying drawings, each of suffixes "0" to "3" attached to the reference numeral for an element means a sequential order of the element among the similar elements designated by the same reference numeral.

As shown in Fig. 1, the third key contact 12₂ is absent in the illustrated key switch 11 with first, second and fourth key contacts 12₀, 12₁ and 12₃ being present. In each of the key switches 11, each of the four key contacts 12₀, 12₁, 12₂ and 12₃ is selectively disposed or removed. The configuration of the presence or absence of each of the key contacts 12 is different switch by switch. All or some of the possible number (2ⁿ-1) of key switches are disposed for the "n" scan lines 13 in the keyboard. In these configurations, a specific key switch 11 outputs through the common four scan lines 13 a specified coded signal, whereby the scan circuits 15 outside the keyboard 10 detects which key switch 11 in the keyboard 10 is depressed.

In an alternative, all of the four key contacts 12 in each key switch 11 may be actually disposed instead of selective disposition, provided that each of the electric leads connecting the electrodes of the four key contacts 12 and the respective four scan lines 13 is selectively removed.

Depression of a specific key switch 11 is implemented by depression of a common key button 17 to make the key contacts 12 in the specific key switch 11 closed at a time, or in other words, to make connection between respective pairs of electrodes in the key contacts 12. One of the electrodes of each contact 12 is connected to a corresponding one of the four scan lines 13, whereas the other of the electrodes of each contact 12 is connected to the ground.

In the above configurations, when one of the key switches in the keyboard, for example, the key switch 11 shown in Fig. 1 is depressed, the key contacts 12₀, 12₁ and 12₃ are closed, whereby the scan lines 13₀, 13₁ and 13₃ are grounded and the scan line 13₂ is maintained at the source potential. The respective potentials of the four scan lines 13 are periodically detected by the scan circuits 15 receiving the 4-bit signals from the output terminals 16 of the key board 10 to thereby determine which key switch is depressed.

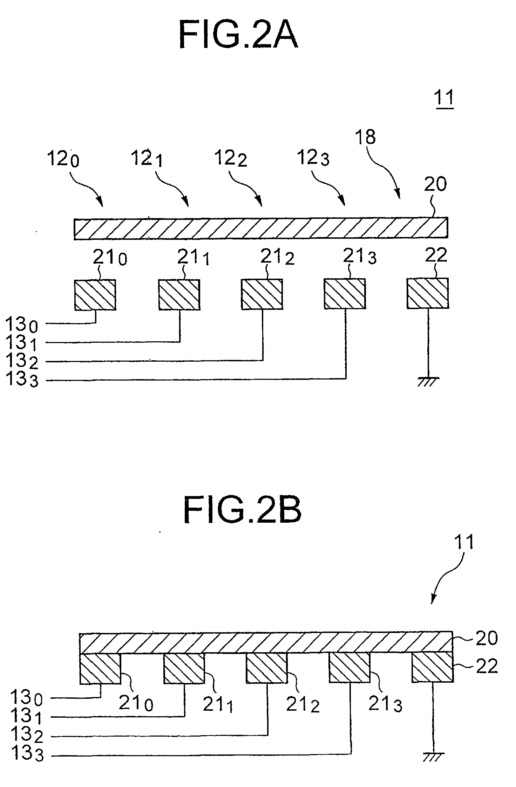

Referring to Figs. 2A and 2B, a specific key switch 11 for use in the keyboard of Fig. 1 is exemplified in a normal state and a depressed state, respectively, of the key button. In Fig. 2A, the exemplified key switch 11 includes all of the four key contacts 12₀, 12₁, 12₂ and 12₃ in the specific key switch 11, and a common additional contact 18. All of the five contacts 12₀, 12₁, 12₂, 12₃ and 18 are implemented by a single common electrode 20 formed as a movable metallic member and five respective electrodes 21₀, 21₁, 21₂, 21₃ and 22 formed as stationary metallic members. The four electrodes 21₀, 21₁, 21₂ and 21₃ for the key contacts 12₀, 12₁, 12₂ and 12₃ are connected to respective scan lines 13₀, 13₁, 13₂ and 13₃, whereas the electrode 22 of the additional contact 18 is connected to the ground. It is to be noted that each of the four electrodes 21₀, 21₁, 21₂ and 21₃ is selectively disposed or removed for each key switch 11 in the keyboard 10.

In Fig. 2B, the common electrode 20 is depressed by the key button not shown in the figure to be in electric contact with the five stationary electrodes 21₀, 21₁, 21₂, 21₃ and 22, whereby all of the four scan lines 15 are grounded in this example. In the case of the key switch 11 depicted in Fig. 1, wherein the third contact is removed, the scan line 13₂ is maintained at the source potential after the depression, with the remaining scan lines 13₀, 13₁ and 13₃ grounded. Thus, a 4-bit coded signal can be output from the keyboard 10 through the four scan lines 13₀, 13₁, 13₂ and 13₃ depending on the key switch 11 depressed at that time.

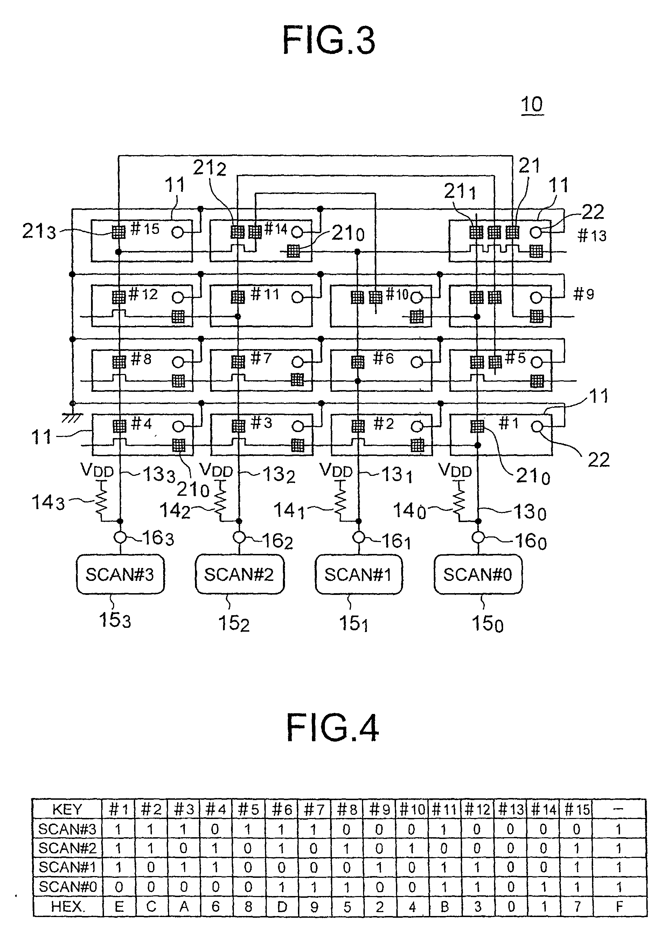

Referring to Fig. 3, a concrete example of the keyboard of the present embodiment includes fifteen key switches 11 (#1 to #15) arranged in a matrix and each having the configuration shown in Figs. 2A and 2B. In each of the key switches 11, the stationary electrodes 21 of the key contacts 12 connected to respective scan lines 13 are depicted by shadowed squares, and the grounded electrode 22 is depicted by a circle. In addition, the configuration that a scan line 13 is shown as passing a shadowed square in a key switch 11 means that the stationary electrode connected to the scan line 11 is a actually disposed in the key switch 11.

For example, in the rightmost column of the key switches 11, key switch #1 includes a single key contact for scan line 13₀, key switch #5 includes three key contacts for scan lines 13₀, 13₁ and 13₂, key switch #9 includes three key contacts for scan lines 13₀, 13₂ and 13₃, and key switch #13 includes four key contacts for, scan lines 13₀, 13₁, 13₂ and 13₃. Thus, the first stationary electrode 21₀ to be connected to the first scan line 13₀ is actually disposed in each of the key switches #1, #5, #9, #13, #2, #3, #4 and #10, as will be understood by tracing the first scan line 13₀ in the keyboard 10 from the output terminal 16₀ thereof. The presence or absence of the other stationary electrodes can be confirmed by tracing each of the scan lines 13. The key switches #1 to #15 deliver 4-bit signals, with the first bit delivered through the first scan line 13₀ and detected by the scan circuit 15₀ being a LSB and the fourth bit delivered through the fourth scan line 13₃ and detected by the scan circuit 153 being a MSB.

Fig. 4 shows the 4-bit signals as well as hexadecimal notations thereof output upon depressing each of the key switches #1 to #15 shown in Fig. 3. For example, depression of the key switch #1 outputs "1110" as the 4-bit signal, or a code E₁₆ in the hexadecimal notation, because the key switch shown in Fig. 3 has only the first electrode 21₀, and depression of the key switch #14 outputs "0001" as the 4-bit signal, or a code 1₁₆ in the hexadecimal notation, because the key switch #14 has the second, third and fourth electrodes 21₁, 21₂ and 21₃ connected to scan lines 13₁, 31₂ and 13₃, respectively. Depressions of the other key switches also output respective 4-bit signals. A key switch for code F₁₆ is absent, because code F₁₆ is delivered upon non-depression of any key switch. By detecting the 4-bit signals, the scan circuits 15 detects which key switch 11 among the key switches in the keyboard 10 is depressed.

In the conventional scanning technique for a keyboard, a plurality (n) of input terminals arranged in x-direction and a plurality (m) of output terminals arranged in y-direction are used for detecting a depressed one of the key switches arranged in x-y direction. In the case wherein n=2 and m=2 in the conventional technique, four output terminals allow detection of only four different states of the key switches except for a double or multiple key depression wherein two or more key switches are depressed at a time. On the other hand, the four output terminals 16₀, 16₁, 16₂ and 16₃ provided in the keyboard 10 of the present embodiment allow detection of sixteen different states of the key switches. The keyboard of the present embodiment is also advantageous over the conventional technique in that the external terminals are implemented solely by output terminals without using input terminals.

In the keyboard of the present invention, "n" output terminals allow detection of (2ⁿ-1) states of the keyboards, or 2ⁿ states if the state of non-depression of any key is included therein.

In the above embodiment, the scan lines 13 are connected to a high potential source line through pull-up resistors 14. However, the scan lines 13 can be connected to a low potential source line (or the ground line) through pull-down resistors instead.

Since the above embodiments are described only for examples, the present invention is not limited to the above embodiments and various modifications or alterations can be easily made therefrom by those skilled in the art without departing from the scope of the present invention.

## Claims

**1.** A keyboard comprising a plurality of key switches (11) each including a fixed number of key contacts (12) and a common key button (17) for making the key contacts (12) closed at a time, and scan lines (13) in number corresponding to the fixed number and each selectively connected to a corresponding one of the key contacts (12) of each of the key switches (11), whereby each of the key switches (11) outputs a specified signal through the scan lines (13) upon depression of the common key button (17).

**2.** The keyboard as defined in claim 1, wherein each of the key switches (11) includes a first electrode (20) disposed common to the key contacts and second electrodes (21) in number corresponding to the fixed number plus one.

**3.** The keyboard as defined in claim 1, wherein the scan lines (13) are connected to a source line through respective pull-up transistors (14).

**5.** A keyboard including a plurality of key switches (11) each including a specified number of key contacts (12) selectively disposed from a fixed number of key contacts and a common key button (17) for making the disposed key contacts closed at a time, and scan lines in number corresponding to the fixed number and each connected to a corresponding one of the disposed key contacts (12) of each of the key switches (11), whereby each of the key switches (11) outputs a specified signal through the scan lines (13) upon depression of the common key button (17).

**6.** The keyboard as defined in claim 5, wherein each of the key switches (11) includes a first electrode (20) disposed common to the key contacts (12) and second electrodes (21) in number corresponding to the fixed number plus one.

**7.** The keyboard as defined in claim 5, wherein the scan lines (13) are connected to a source line through respective pull-up transistors (14).
